# EUROPEAN PATENT APPLICATION

(11) **EP 4 579 967 A1**
(43) Date of publication of application: **02.07.2025**
(21) Application number: 23857424.8
(22) Date of filing: 24.08.2023
(51) Int. Cl.: H01S 5/042, H01S 5/11, H01S 5/18

(54) **TWO-DIMENSIONAL PHOTONIC CRYSTAL LASER**

(30) Priority: 25.08.2022 JP 2022134484
(71) Applicant: Kyoto University, Kyoto-shi, Kyoto 606-8501 (JP)
(72) Inventor: NODA, Susumu, Kyoto-shi, Kyoto 606-8501 (JP); YOSHIDA, Masahiro, Kyoto-shi, Kyoto 606-8501 (JP); DE ZOYSA, Menaka, Kyoto-shi, Kyoto 606-8501 (JP); INOUE, Takuya, Kyoto-shi, Kyoto 606-8501 (JP)
(74) Representative: Hoeger, Stellrecht & Partner Patentanwälte mbB
(86) International application number: PCT/JP2023/030563
(87) International publication number: WO 2024/043316

(57) **Abstract**

Provided is a two-dimensional photonic crystal laser capable of making an intensity distribution of light in a cross section of a laser beam close to being uniform. A two-dimensional photonic crystal laser (10) includes: an active layer (11); a two-dimensional photonic crystal layer (12) provided on one face of the active layer (11), in which modified refractive index regions (122) are periodically and two-dimensionally disposed in a base member (121) of a plate shape, the modified refractive index regions (122) having a refractive index different from the refractive index of the base member (121); and a first electrode (171) and a second electrode (172) provided so as to sandwich the active layer (11) and the two-dimensional photonic crystal layer (12) in a stacking direction; in which the first electrode (171) has an opening (175), and at least a part of a projection (1721) of a circumscribed circle of the second electrode (172) onto the first electrode (171) is located in the opening (175), and at least a part of periphery of the opening (175) of the first electrode (171) protrudes into the projection (1721).

## Description

### TECHNICAL FIELD

The present invention relates to a two-dimensional photonic crystal laser that amplifies light using a two-dimensional photonic crystal.

### BACKGROUND ART

A two-dimensional photonic crystal laser generally includes a layered body having an active layer and a two-dimensional photonic crystal layer which are sandwiched by a pair of clad layers, and further includes a pair of electrodes (electrode pair) that sandwich the layered body. The active layer generates light emission with a specific light emission wavelength band upon being supplied with carriers (positive holes, electrons) from the electrode pair. The two-dimensional photonic crystal layer has a configuration including a base member of a plate shape in which modified refractive index regions whose refractive index differs from that of the base member are periodically disposed two-dimensionally. The modified refractive index region is made of a hole (air) formed in the base member, or a member having a refractive index different from a refractive index of the base member.

In such a two-dimensional photonic crystal laser, only light of a predetermined wavelength corresponding to a period length of the disposition of the modified refractive index regions out of light generated in the active layer is amplified in the two-dimensional photonic crystal layer and performs laser oscillation, and a laser beam is emitted in a direction perpendicular to the two-dimensional photonic crystal layer. However, since the electrode exists in the direction perpendicular to the two-dimensional photonic crystal layer, the laser beam may be blocked by the electrode depending on a position or a shape of the electrode.

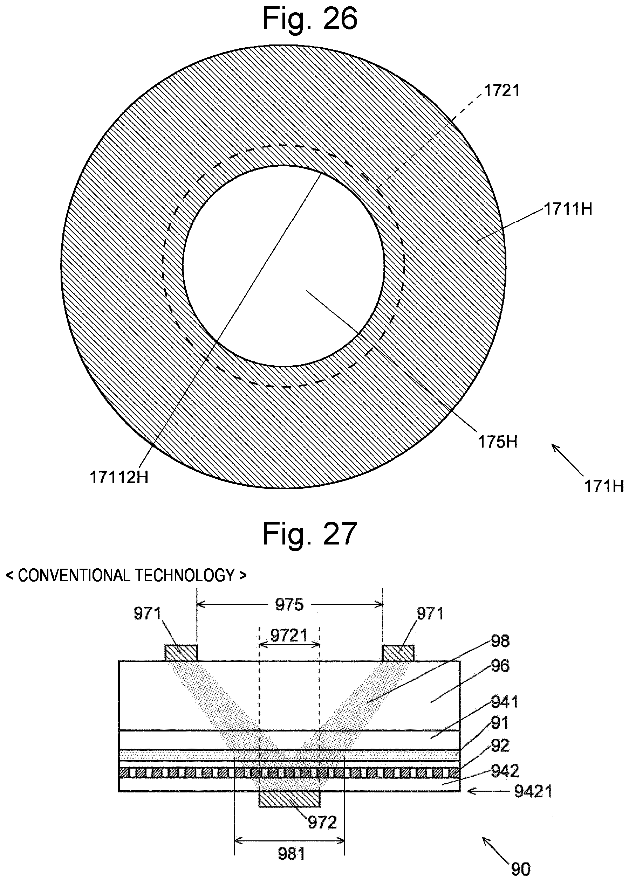

Therefore, in the two-dimensional photonic crystal laser described in Patent Literature 1, a window-shaped electrode 971 is used in which a window 975 formed by hollowing out a portion of a plate-shaped conductor member is provided in one of the pair of electrodes (provided on a surface of a substrate 96) (see Fig. 27). The electrode 972 opposite to the window-shaped electrode 971 is provided on a surface 9421 of a second cladding layer 942 and does not have a window. In this two-dimensional photonic crystal laser, the laser beam emitted toward the window-shaped electrode 971, among the laser beams emitted in both directions perpendicular to the two-dimensional photonic crystal layer 92, passes through the window 975 and goes to the outside of the two-dimensional photonic crystal laser 90 without being hindered by the window-shaped electrode 971. On the other hand, the laser beam emitted toward the electrode 972 would be lost, but if a reflection layer (not illustrated) is provided on the surface 9421 of the second cladding layer 942, the laser beam can be emitted toward the window-shaped electrode 971. Note that a layer denoted by reference numeral 941 in Fig. 27 is a first cladding layer, and, together with the second cladding layer 942, works to confine light generated in the active layer 91 in a direction perpendicular to the layers (thereby, promote amplification of light in the two-dimensional photonic crystal layer 92).

In the two-dimensional photonic crystal laser described in Patent Literature 1, the electrode 972 has a smaller area than the window 975, and is disposed at a position where the entire electrode 972 is inside the window 975 when projected onto the window-shaped electrode 971. Consequently, the electric current 98 flowing between the window-shaped electrode 971 and the electrode 972 flows so as to have a V shape on a cross section (cross section illustrated in Fig. 27) that is perpendicular to the active layer 91 and includes the electrode 972. Then, in the cross section parallel to the active layer 91 and the two-dimensional photonic crystal layer 92, a donut-shaped electric current distribution having a smaller electric current density around its center is formed at a position away from the surface 9421 of the second cladding layer 942. Therefore, in the two-dimensional photonic crystal laser described in Patent Literature 1, it is attempted to dispose the active layer 91 at a position as close to the surface 9421 of the second cladding layer 942 as possible to make the electric current density in an electric current supply region in the active layer 91, that is, a light emitting region 981 as uniform as possible.

### CITATION LIST

### PATENT LITERATURE

Patent Literature 1: WO 2007/029538 A
Patent Literature 2: JP 2008-243962 A
Patent Literature 3: WO 2017/150387 A

### SUMMARY OF INVENTION

### TECHNICAL PROBLEM

In the two-dimensional photonic crystal laser described in Patent Literature 1, even if the active layer is disposed at a position close to a mounting surface as described above, the electric current density around the center of the light emitting region 981 is smaller than that in the periphery. Then, the light emission intensity in the active layer 91 also becomes non-uniform with respect to the position. Furthermore, in a laser beam oscillated by amplifying the light generated in the active layer 91 in the two-dimensional photonic crystal layer 92, there arises a non-uniformity in which the intensity of light around the center of the cross section is lower than that in the periphery.

An object of the present invention is to provide a two-dimensional photonic crystal laser capable of making the electric current density distribution in a light emitting region of an active layer closer to being uniform than before.

### SOLUTION TO PROBLEM

A two-dimensional photonic crystal laser according to the present invention made to solve the above problems includes:
an active layer;
a two-dimensional photonic crystal layer provided on one face of the active layer, in which modified refractive index regions are periodically and two-dimensionally disposed in a base member of a plate shape, the modified refractive index regions having a refractive index different from the refractive index of the base member; and
a first electrode and a second electrode provided so as to sandwich the active layer and the two-dimensional photonic crystal layer in a stacking direction;
in which
the first electrode has an opening, and
a projection of a circumscribed circle of the second electrode onto the first electrode is located in the opening, and
at least a part of periphery of the opening of the first electrode protrudes into the projection.

In the two-dimensional photonic crystal laser according to the present invention, at least a part of the first electrode on the periphery of the opening protrudes into the projection of the circumscribed circle of the second electrode onto the first electrode, an electric current can be easily supplied to around the center of the light emitting region in the active layer as compared with the conventional two-dimensional photonic crystal laser using a window-shaped electrode without such protrusion. Consequently, the electric current density distribution in the light emitting region of the active layer can be close to uniform. In addition, in a laser beam which oscillates when light generated in the light emitting region is amplified by the two-dimensional photonic crystal layer and is emitted to the outside through the opening (which is the "window" of the first electrode), a decrease in the intensity of light around the center of the cross section is suppressed.

When the entire projection of the circumscribed circle of the second electrode onto the first electrode is not located in the opening of the first electrode, an electric current cannot be appropriately supplied from a sub-region to around the center of the light emitting region in the active layer. Therefore, in the present invention, the projection of the circumscribed circle of the second electrode onto the first electrode is located in the opening of the first electrode. Here, the entire projection may be located in the opening, but it is sufficient if at least a part of the projection is located in the opening (that is, even if other than the part is located outside the opening).

In the two-dimensional photonic crystal laser according to the present invention, it is preferable that a projection of the second electrode onto the first electrode (referred to as "second projection") is located in the opening of the first electrode, and at least a part of the periphery of the opening protrudes into the second projection.

As described above, when not only the projection of the circumscribed circle of the second electrode onto the first electrode but also the projection (second projection) of the second electrode itself onto the first electrode is located in the opening of the first electrode, and at least a part of the periphery of the opening protrudes into the second projection, the electric current can be more reliably supplied to around the center of the light emitting region of the active layer.

In the configuration as described above in which the second projection is located in the opening of the first electrode and at least a part of the periphery of the opening protrudes into the second projection, a non-conductive portion may be formed in the second electrode, where the non-conductive portion is at least a part of a third projection which is a projection onto the second electrode of the part of the first electrode protruding into the second projection.

The part of the first electrode protruding into the second projection blocks the laser beam emitted from the two-dimensional photonic crystal layer. Therefore, by forming the non-conductive portion in at least a part of the third projection in the second electrode, it is possible to decrease the electric current supplied into a portion of the active layer and the two-dimensional photonic crystal layer corresponding to the projection of the part of the first electrode, whereby the light emission in the portion is suppressed. This reduces a loss of the laser beam generated by the light emission in the portion by being blocked by the sub-region. As a result, light emission efficiency can be increased.

In the two-dimensional photonic crystal laser according to the present invention, the first electrode may include a main region surrounding the projection or the second projection, and a sub-region of a line shape extending from the main region into the projection.

By using the first electrode including such a sub-region of a line shape, it is easy to supply more electric current to around the center of the light emitting region through the sub-region. Although only one sub-region may be provided, it is preferable to provide a plurality of the sub-regions in order to supply more electric current to around the center of the light emitting region.

It is preferable that the first electrode including such a sub-region of a line shape includes a plurality of sub-regions having different lengths. If a plurality of sub-regions having the same length are provided from the main region toward the inside of the opening, the density of the sub-region is higher around the center of the opening than in the periphery. But the electric current density around the center of the active layer can be controlled by adjusting the density of the sub-region around the center of the opening by using a plurality of sub-regions having different lengths. Note that the configuration "a plurality of sub-regions having different lengths" only needs to include at least two sub-regions having different lengths, and may include a case where some of the plurality of sub-regions (a plurality of sub-regions fewer than the preceding "plurality of sub-regions") have the same length. Further, the electric current density around the center of the active layer can be controlled by using a plurality of sub-regions having different widths, thicknesses, and/or materials together with or instead of the lengths.

In the two-dimensional photonic crystal laser according to the present invention, it is possible to adopt a configuration in which the first electrode is physically divided into a plurality of electrodes.

Here, the case where the first electrode is "physically divided" into the plurality of electrodes includes the case where a space is placed between divided electrodes, an object made of an insulator or a semiconductor is provided between the divided electrodes, and the like.

In the two-dimensional photonic crystal laser according to the present invention, depending on the magnitude of the protrusion of the first electrode into the projection, the electric current density around the center of the light emitting region may be larger or smaller than the periphery with respect to an intended electric current density distribution. In such a case, by physically dividing the first electrode into a plurality of electrodes and adjusting the magnitude of the electric current supplied from each of the plurality of electrodes, the electric current density in the light emitting region can be brought close to the intended distribution. In addition, when an undesirable spatial distribution occurs in the temperature in the light emitting region during use of the two-dimensional photonic crystal laser, it is recommended that the magnitude of the electric current supplied from each of the plurality of electrodes is adjusted in order to suppress the spatial distribution.

If the first electrode is disposed at a position farther from the active layer than the second electrode is, the shape of the light emitting region in the active layer is close to that of the second electrode. In such a case, regardless of whether or not the first electrode has the opening, depending on the position of the first electrode, the electric current density around the center of the light emitting region may be smaller than that in the periphery, and accordingly, the light emission intensity around the center may be small. Therefore, by disposing the first electrode within the projection of the circumscribed circle of the second electrode onto the first electrode, the electric current density around the center of the light emitting region can be increased, and the light emission intensity around the center can be suppressed from being weakened.

In other words, another mode of the two-dimensional photonic crystal laser according to the present invention includes:
an active layer;
a two-dimensional photonic crystal layer provided on one face of the active layer, in which modified refractive index regions are periodically and two-dimensionally disposed in a base member of a plate shape, the modified index regions having a refractive index different from the refractive index of the base member; and
a first electrode and a second electrode provided so as to sandwich the active layer and the two-dimensional photonic crystal layer in a stacking direction;
in which
the first electrode is disposed at a position farther from the active layer than the second electrode is, and
at least a part of the first electrode exists in the projection of the circumscribed circle of the second electrode onto the first electrode.

### ADVANTAGEOUS EFFECTS OF INVENTION

With the two-dimensional photonic crystal laser according to the present invention, it is possible to make the electric current density distribution in the light emitting region of the active layer closer to being uniform than before.

### BRIEF DESCRIPTION OF DRAWINGS

[Fig. 1] A perspective view illustrating a first embodiment of a two-dimensional photonic crystal laser according to the present invention.
[Fig. 2] A plan view illustrating a configuration of a two-dimensional photonic crystal layer in the two-dimensional photonic crystal laser of the first embodiment.
[Fig. 3] A top view in which a first electrode in the two-dimensional photonic crystal laser of the first embodiment is indicated by a solid line and a projection of a second electrode is indicated by a broken line.
[Fig. 4A] A view illustrating a path through which an electric current flows in the two-dimensional photonic crystal laser of the first embodiment by an A-A cross-section in Fig. 3.
[Fig. 4B] A view illustrating a path through which an electric current flows in the two-dimensional photonic crystal laser of the first embodiment by a B-B cross-section in Fig. 3.
[Fig. 5] A longitudinal cross-section view illustrating a two-dimensional photonic crystal laser of a modification of the first embodiment.
[Fig. 6] A graph illustrating a result obtained by calculating an electric current density distribution in an active layer for the two-dimensional photonic crystal lasers of the first embodiment and a comparative example.
[Fig. 7A] A view illustrating a result obtained by calculating a photonic density distribution in an active layer for the two-dimensional photonic crystal lasers of the first embodiment.
[Fig. 7B] A view illustrating a result obtained by calculating a photonic density distribution in an active layer for the two-dimensional photonic crystal laser of the comparative example.
[Fig. 8A] A view illustrating a result obtained by calculating a photonic density distribution in a cross section of a laser beam obtained by the two-dimensional photonic crystal lasers of the first embodiment.
[Fig. 8B] A view illustrating a result obtained by calculating a photonic density distribution in a cross section of a laser beam obtained by the two-dimensional photonic crystal lasers of the comparative example.
[Fig. 9] A perspective view illustrating a second embodiment of the two-dimensional photonic crystal laser according to the present invention.
[Fig. 10] A top view in which a first electrode in the two-dimensional photonic crystal laser of the second embodiment is indicated by a solid line and a projection of a second electrode is indicated by a broken line.
[Fig. 11] A graph illustrating a result obtained by calculating an electric current density distribution in an active layer for the two-dimensional photonic crystal laser of the second embodiment and the two-dimensional photonic crystal laser of the comparative example.
[Fig. 12] A graph illustrating a result obtained by calculating a temperature distribution in an active layer for the two-dimensional photonic crystal laser of the second embodiment and the two-dimensional photonic crystal laser of the comparative example.
[Fig. 13] A photograph indicating an appearance of a manufactured two-dimensional photonic crystal laser of the second embodiment.
[Fig. 14] A graph illustrating an experimentally obtained result of a light emission intensity distribution using the manufactured two-dimensional photonic crystal laser of the second embodiment.
[Fig. 15] A view illustrating a shape of a cross section of a laser beam for four examples in which a ratio of a first electric current to a second electric current is different in the two-dimensional photonic crystal laser of the second embodiment.

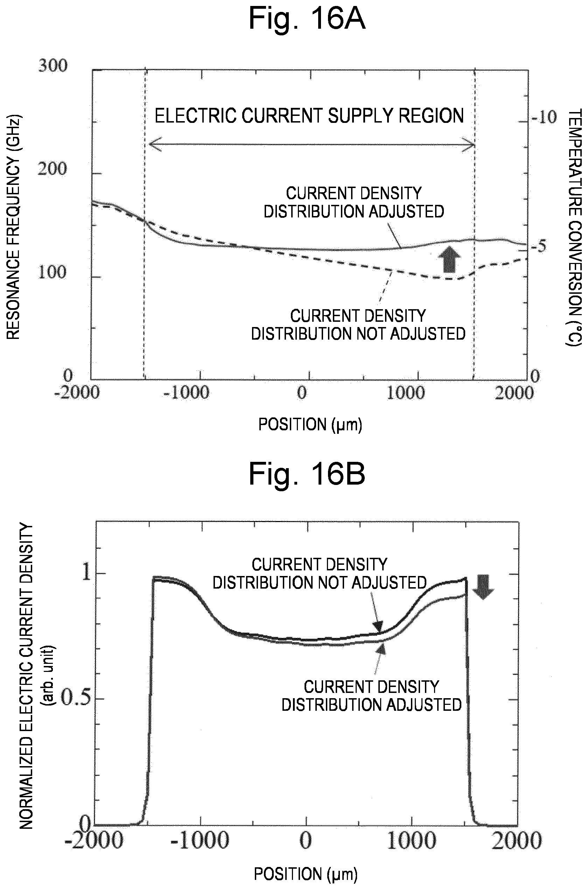

[Fig. 16A] A graph illustrating an example of a difference in resonance frequency depending on a position (based on the center of a region into which an electric current is supplied) in a two-dimensional photonic crystal layer caused by a manufacturing error of the two-dimensional photonic crystal layer in the two-dimensional photonic crystal laser according to the second embodiment for a case where the electric current density distribution is not adjusted (broken line) and for a case where the electric current density distribution is adjusted so as to alleviate the difference in resonance frequency (solid line).
[Fig. 16B] A graph illustrating a normalized electric current density distribution (normalized by the maximum value of the electric current density) in a case where the electric current density distribution is not adjusted and in a case where the electric current density distribution is adjusted so as to alleviate the difference in resonance frequency in the example of Fig. 16A.
[Fig. 16C] A view illustrating a shape of the cross section of the laser beam in the example of Fig. 16A in a case where the electric current density distribution is not adjusted (left diagram) and in a case where adjusted so as to alleviate the difference in resonance frequency (right diagram).
[Fig. 17] A perspective view illustrating a third embodiment of the two-dimensional photonic crystal laser according to the present invention.
[Fig. 18] A top view in which a first electrode in the two-dimensional photonic crystal laser of the third embodiment is indicated by a solid line and a projection of a second electrode is indicated by a broken line.
[Fig. 19] A perspective view illustrating a fourth embodiment of the two-dimensional photonic crystal laser according to the present invention.
[Fig. 20] A plan view illustrating a first electrode (left diagram) and a second electrode (right diagram) in the two-dimensional photonic crystal laser of the fourth embodiment.
[Fig. 21A] A plan view illustrating a modification of the first electrode.
[Fig. 21B] A plan view illustrating another modification of the first electrode.
[Fig. 21C] A plan view illustrating another modification of the first electrode.
[Fig. 21D] A plan view illustrating another modification of the first electrode.
[Fig. 21E] A plan view illustrating another modification of the first electrode.
[Fig. 21F] A plan view illustrating another modification of the first electrode.
[Fig. 21G] A plan view illustrating another modification of the first electrode.
[Fig. 22] A longitudinal cross-section view illustrating a two-dimensional photonic crystal laser of a further modification of the first embodiment.
[Fig. 23] A plan view illustrating a modification of the first electrode in the third embodiment.
[Fig. 24] A plan view illustrating a modification of the second electrode.
[Fig. 25A] A plan view illustrating another modification of the second electrode.
[Fig. 25B] A plan view illustrating another modification of the second electrode.
[Fig. 25C] A plan view illustrating another modification of the second electrode.
[Fig. 26] A top view in which a first electrode in the two-dimensional photonic crystal laser of another modification is indicated by a solid line and a projection of a second electrode is indicated by a broken line.
[Fig. 27] A longitudinal cross-section view illustrating an example of a conventional two-dimensional photonic crystal laser having a window-shaped electrode.

### DESCRIPTION OF EMBODIMENTS

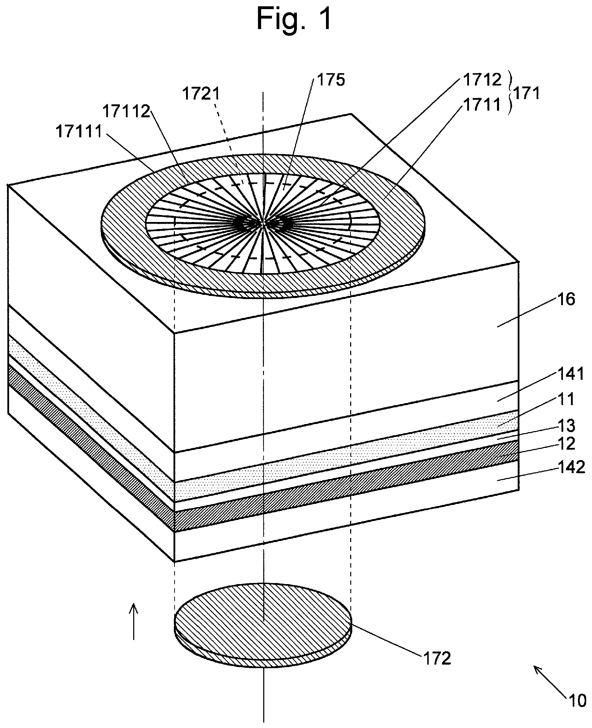

Embodiments of the two-dimensional photonic crystal laser according to the present invention will be described with reference to Figs. 1 to 26.

### (1) First Embodiment

### (1-1) Configuration of two-dimensional photonic crystal laser of first embodiment

As illustrated in Fig. 1, a two-dimensional photonic crystal laser 10 of the first embodiment has a configuration in which a first electrode 171, a substrate 16, a first cladding layer 141, an active layer 11, a spacer layer 13, a two-dimensional photonic crystal layer 12, a second cladding layer 142, and a second electrode 172 are sequentially stacked in the above-described order. However, the order of the active layer 11 and the two-dimensional photonic crystal layer 12 may be opposite to that described above. In Fig. 1, for convenience, the first electrode 171 is illustrated as an upper side, and the second electrode 172 is illustrated as a lower side. However, the orientation of the two-dimensional photonic crystal laser 10 at the time of use is not limited to that illustrated in Fig. 1. Hereinafter, the configurations of the layers and the electrodes will be described.

The active layer 11 emits light having a specific wavelength band upon being supplied with electric charges from the first electrode 171 and the second electrode 172. As a material of the active layer 11, for example, an InGaAs/AlGaAs multiple quantum well (emission wavelength band: 935 to 945 nm) can be used.

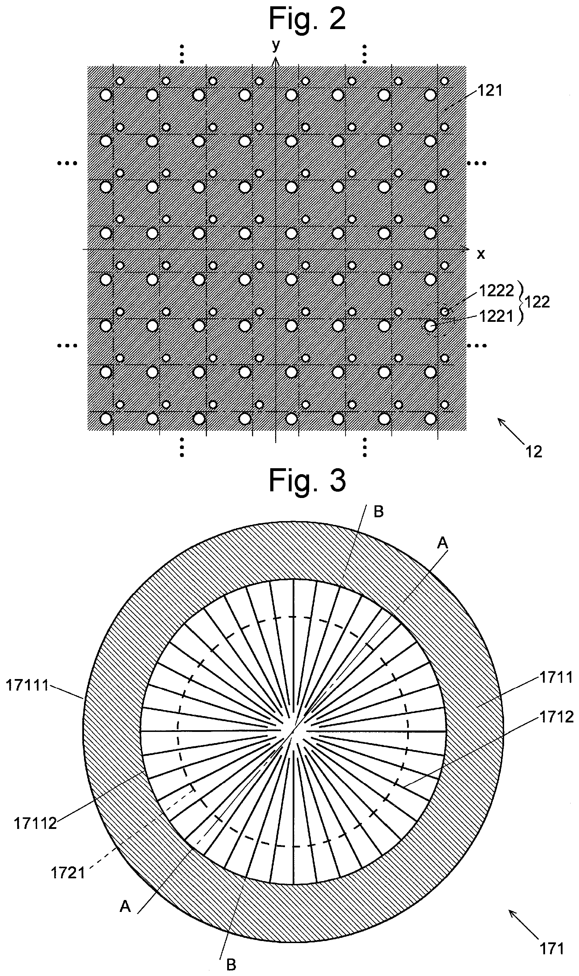

As illustrated in Fig. 2, in the two-dimensional photonic crystal layer 12, modified refractive index regions 122 having a refractive index different from that of a base member 121 of a plate shape are disposed one by one for lattice points of a two-dimensional lattice. Note that Fig. 2 illustrates only a part of the two-dimensional photonic crystal layer 12 in an enlarged manner. In an actual two-dimensional photonic crystal layer 12, a large number of modified refractive index regions 122 are disposed over a range equivalent to an outer edge of the first electrode 171. In an example illustrated in Fig. 2, the two-dimensional lattice is a square lattice, but another two-dimensional lattice such as a rectangular lattice or a triangular lattice may be used. A lattice point period (length) a of the square lattice is appropriately determined according to a material of the base member 121 and the emission wavelength band in the active layer 11. For example, p-type GaAs (p-type semiconductor) can be used as the material of the base member 121. Although a hole is typically used for the modified refractive index region 122, a member having a refractive index different from a refractive index of the base member 121 may be used instead of the hole.

In the example illustrated in Fig. 2, a combination of two holes (instead of the hole, a member having a refractive index different from a refractive index of the base member 121 may be used) of a first modified refractive index region 1221 and a second modified refractive index region 1222 is used as one modified refractive index region 122. Here, as the first modified refractive index region 1221, a region of a planar shape having an area larger than that of the second modified refractive index region 1222 is used, but the first modified refractive index region 1221 and the second modified refractive index region 1222 may have the same size. By using a modified refractive index region in which two holes or members are combined in this manner, it is possible to suppress light from being localized in a partial region in the two-dimensional photonic crystal layer 12 and to oscillate a laser beam from a wide range in the two-dimensional photonic crystal layer 12 (see Patent Literatures 2 and 3). Note that in the present invention, the modified refractive index region is not limited to the example illustrated in Fig. 2, and a modified refractive index region including only one hole or modified refractive index region or a modified refractive index region including three or more holes or members may be used. In addition, the planar shape of individual holes or members is circular in the example illustrated in Fig. 2, but may be another shape such as a triangle or a quadrangle.

The first cladding layer 141 and the second cladding layer 142 work to supply electric charges from the first electrode 171 and the second electrode 172 and work to suppress inplane guided light guided in parallel with the two-dimensional photonic crystal layer 12 within this layer from leaking from the layer. In order for the first cladding layer 141 and the second cladding layer 142 to work to supply electric charges, a n-type semiconductor (for example, n-type Al_{0.37}Ga_{0.63}As) and an p-type semiconductor (for example, p-type Al_{0.37}Ga_{0.63}As) can be used respectively therefor, for example, (note that the p-type semiconductor is used as the material of the base member 121 of the two-dimensional photonic crystal layer 12 for the same reason as for the second cladding layer 142 to work to supply electric charges from the second electrode 172).

The spacer layer 13 is provided to suppress electrons supplied from the first electrode 171 from passing through the active layer 11 (consequently, combining with positive holes on the first electrode 171 side than in the active layer 11) while allowing positive holes supplied from the second electrode 172 to pass and to be introduced into the active layer 11. For example, p-type Al_{0.45}Ga_{0.55}As can be used as a material of the spacer layer 13.

The substrate 16 that is sufficiently thicker than that for other layers is used in order to maintain the mechanical intensity of the entire two-dimensional photonic crystal laser 10 and to make the distance between the first electrode 171 and the active layer 11 larger than the distance between the second electrode 172 and the active layer 11. As a material of the substrate 16, an n-type semiconductor is used for the same reason as in the first cladding layer 141.

The second electrode 172 is made of a conductive material and has a circular planar shape. Note that, in Fig. 1, in order to illustrate the second electrode 172, the second electrode 172 is illustrated to be separated downward from the second electrode 142, but actually, the second electrode 172 is in contact with a lower surface of the second cladding layer 142.

The first electrode 171 is made of a conductive material, and has a shape in which a main region 1711 and a sub-region 1712 are combined as illustrated in Fig. 3. The main region 1711 has a planar shape of a donut shape obtained by hollowing out the inside of a first circle (an outer edge 17111 of the first electrode 171) with a second circle 17112 having a smaller diameter than the outer edge 17111 and having the same center as the outer edge 17111. The sub-region 1712 has a line shape extending from a circumference portion of the second circle 17112 into the second circle 17112. Among the second circle 17112, a portion where the sub-region 1712 does not exist is an opening 175 of the first electrode 171. The opening 175 serves as a window through which the laser beam passes.

In the first embodiment, 40 sub-regions 1712 are provided at 9° intervals so as to extend radially from the center of the second circle 17112. However, each of the sub-regions 1712 is not formed within a predetermined distance from the center of the second circle 17112, and the sub-region 1712 does not exist around the center. Among the 40 sub-regions 1712, 10 sub-regions provided at 36° intervals are longer than the other 30 sub-regions 1712 and extend to a position closest to the center of the second circle 17112. In addition, the 10 sub-regions 1712 provided at positions shifted by 18° from the 10 sub-regions 1712 are longer than the other 20 sub-regions 1712, and extend to a position closer to the center of the second circle 17112 than the 20 sub-regions 1712 do. As described above, by providing the plurality of sub-regions 1712 having different lengths inside the main region 1711, the density of the sub-regions 1712 around the center of the second circle 17112 and around the main region 1711 can be close to being uniform.

Since the second electrode 172 is circular, the circumscribed circle of the second electrode 172 coincides with the second electrode 172 itself. The projection of the circumscribed circle of the second electrode 172 onto the first electrode 171 (the "projection") and the projection of the second electrode 172 itself onto the first electrode 171 (the "second projection") are located in the opening 175. Hereinafter, in the present embodiment, these "projection" and "second projection" are collectively referred to as "projection 1721". A portion of the sub-region 1712 protrudes from the circumference portion of the second circle 17112 into the projection 1721. Therefore, a portion of the periphery of the opening 175 also protrudes into the projection 1721.

### (1-2) Operation of two-dimensional photonic crystal laser of first embodiment

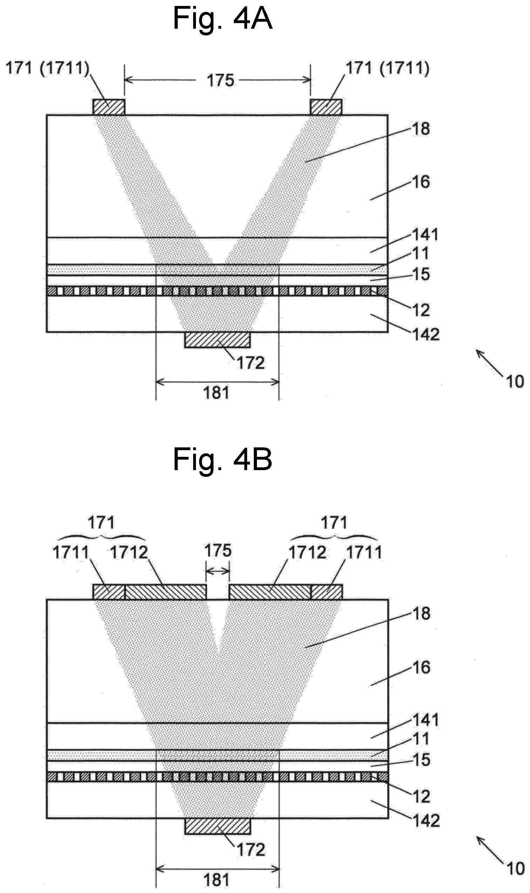

Next, an operation of the two-dimensional photonic crystal laser 10 of the first embodiment will be described. By applying a predetermined voltage between the first electrode 171 and the second electrode 172, an electric current flows between both electrodes. Here, a path of this electric current will be described with reference to Fig. 4A and Fig. 4B. Fig. 4A illustrates an electric current path in the A-A cross section in Fig. 3, and Fig. 4B illustrates an electric current path in the B-B cross section. The A-A cross section is a cross section that is perpendicular to each layer included in the two-dimensional photonic crystal laser 10, passes through the center of the second circle 17112, and does not pass through the sub-region 1712. The B-B cross section is a cross section that is perpendicular to each layer included in the two-dimensional photonic crystal laser 10, passes through the center of the second circle 17112 and the sub-region 1712.

As illustrated in Fig. 4A, since the sub-region 1712 does not exist in the A-A cross section, the electric current 18 flows between the main region 1711 of the first electrode 171 and the second electrode 172. In this cross section, at the position of the active layer 11, the electric current density supplied to around the center of the light emitting region 181, which is a region into which the electric current 18 is supplied, is smaller than that of the periphery. On the other hand, as illustrated in Fig. 4B, since the sub-region 1712 exists in the B-B cross section, the electric current density supplied to around the center of the light emitting region 181 can be made larger than that to the A-A cross section. Therefore, by providing the sub-region 1712 (a part of the first electrode 171 protruding into the projection 1721) in the first electrode, it is possible to increase the electric current density around the center of the light emitting region 181 as compared with the case where there is no sub-region 1712, and it is possible to make the electric current density of the entire light emitting region 181 close to being uniform.

By supplying an electric current into the light emitting region 181 of the active layer 11 in this manner, light emission having a wavelength within a predetermined wavelength band corresponding to the material of the active layer 11 is generated from the light emitting region 181. The intensity of the light emission also becomes close to being uniform in the entire light emitting region 181 corresponding to the electric current density. The light emission thus generated is selectively amplified by resonance of light having a resonance wavelength corresponding to the period length of the square lattice in the two-dimensional photonic crystal layer 12, and laser oscillation occurs.

The oscillated laser beam is emitted from both surfaces of the two-dimensional photonic crystal layer 12 in a direction perpendicular to the two-dimensional photonic crystal layer 12. Among them, the laser beam emitted toward the first electrode 171 side passes through the opening 175 and is extracted to the outside of the two-dimensional photonic crystal laser 10. On the other hand, out of the laser beams emitted toward the second electrode 172 side, a laser beam incident on the second electrode 172 is reflected by the second electrode 172 toward the first electrode 171 side, passes through the opening 175, and is extracted to the outside of the two-dimensional photonic crystal laser 10. Out of the laser beams emitted to the second electrode 172 side, a laser beam that has reached the periphery of the second electrode 172 passes through the lower surface of the second cladding layer 142. However, if a reflector (not illustrated) configured to reflect the laser beam is provided in the periphery of the second electrode 172, the laser beam is reflected by the reflector, travels toward the first electrode 171 side, passes through the opening 175, and is extracted to the outside of the two-dimensional photonic crystal laser 10.

Corresponding to the distribution of the intensity of light emission in the light emitting region 181, also in the cross section of the laser beam extracted to the outside of the two-dimensional photonic crystal laser 10, the intensity distribution of light is closer to a unimodal shape (distribution in which the center is largest and gradually decreases as it goes away from the center) than in the case where the sub-region 1712 is not provided.

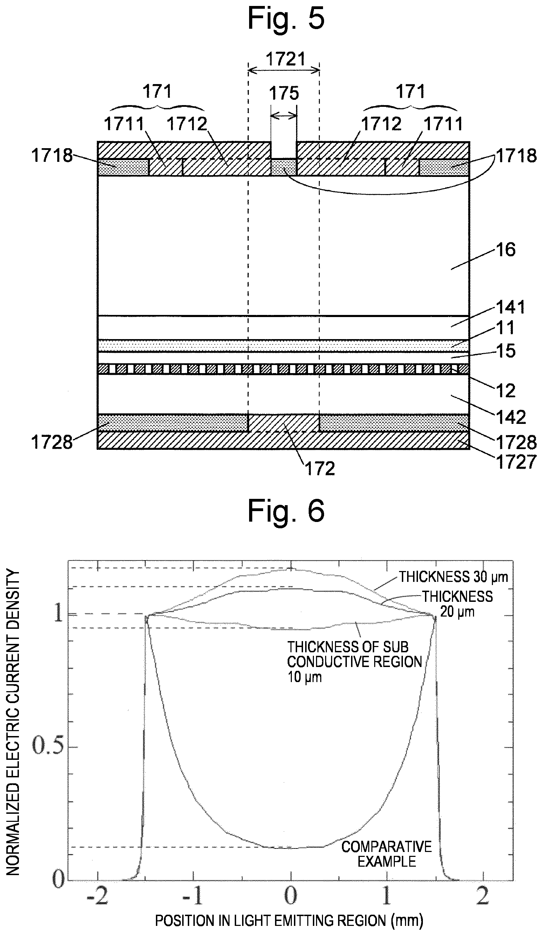

An area included inside the projection 1721 out of the first electrode 171, is larger than the area outside the projection 1721. Consequently, it is possible to avoid concentration of the electric current density near the outer edge of the light emitting region 181 and to enhance uniformity of the electric current density in the light emitting region 181. At that time, in at least a part outside the projection 1721 out of the first electrode 171, the conductor material constituting the first electrode 171 may not be directly formed on an upper surface of the substrate 16, and the conductor material may be formed on the insulating film 1718 after the insulating film 1718 made of an insulator material is formed on the upper surface of the substrate 16 (Fig. 5). In a case where such an insulating film is provided, only a portion without the insulating film 1718 out of the region where the conductor material is provided functions as the first electrode 171, so that the areas inside and outside the projection 1721 out of the first electrode 171 can be adjusted by the insulating film.

In Fig. 6, a result obtained by calculating an electric current density in an active layer for the two-dimensional photonic crystal laser of each of the first embodiment and a comparative example is indicated in a graph. In the calculation of the first embodiment, the distance between the first electrode 171 and the active layer 11 (in a direction perpendicular to the active layer 11) is 0.15 mm, and the distance between the second electrode 172 and the active layer 11 (the same) is 3.7 µm. In other words, the first electrode 171 is disposed at a position farther from the active layer 11 than the second electrode 172 is. At a position outside the projection 1721, the above-described insulating film 1718 is provided between the substrate 16 and the entire conductor material constituting the first electrode 171. The diameter of the second electrode 172 was 3 mm, and the diameter of the second circle 17112 was 3.4 mm. The length of the sub-region 1712 was set to 1.65 mm for the longest 10 sub-regions, 1.50 mm for the next longest 10 sub-regions, and 1.25 mm for the shortest 20 sub-regions. The width of the sub-region 1712 was 0.017 mm for the longest 10 sub-regions and the next longest 10 sub-regions, and 0.013 mm for the shortest 20 sub-regions. **In** addition, calculations were performed for three types of cases where the thickness of the sub-region 1712 was 10 µm, 20 µm, and 30 µm. As a comparative example, calculation was performed for a two-dimensional photonic crystal laser having a configuration in which the sub-region 1712 was removed from the two-dimensional photonic crystal laser 10 of the first embodiment (the other configurations are the same as those of the first embodiment). In both the first embodiment and the comparative example, the calculation was performed assuming that a voltage of 1.6 V is applied between the first electrode 171 and the second electrode 172. In each calculation result, a value at a position 1.5 mm away from the center of the light emitting region (a position immediately above the outer edge of the second electrode 172) was normalized to "1".

From the graph of Fig. 6, the value obtained by dividing the electric current density at the outer edge of the light emitting region (a horizontal axis value of the graph was ±1.5 mm) by the electric current density at the center of the light emitting region (the same was 0 mm) was less than 0.2 in the comparative example, whereas the value was 0.9 to 1.2 (up to the second decimal place, 0.94 to 1.17) in the first embodiment, which was higher than that in the comparative example. This result indicates that the uniformity of the electric current density in the light emitting region is higher in the first embodiment than in the comparative example.

In addition, when comparing the three calculation results of the first embodiment, it can be seen that the electric current density at the center of the light emitting region can be increased as the thickness of the sub-region 1712 is increased. This is because the electrical resistance decreases as the thickness increases in a case where the width of the sub-region 1712 is the same, and more electric current flows through the sub-region 1712.

More generally speaking, the electric current density at the center of the light emitting region can be increased as the electric resistance of a portion in the projection 1721 out of the first electrode 171 is decreased. Specifically, the thickness or the width of the sub-region 1712 in the projection 1721 is increased, or the number of sub-regions 1712 is increased, for example.

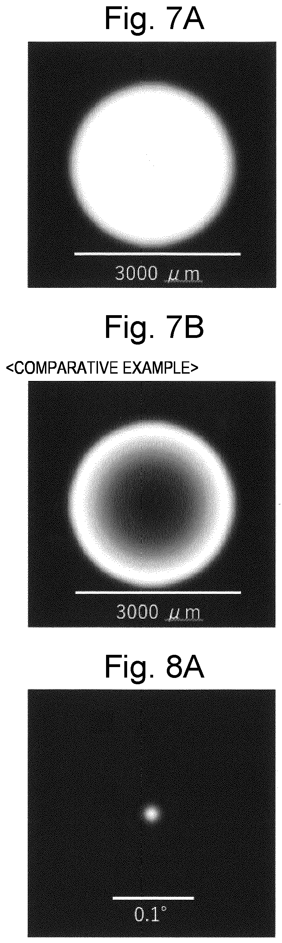

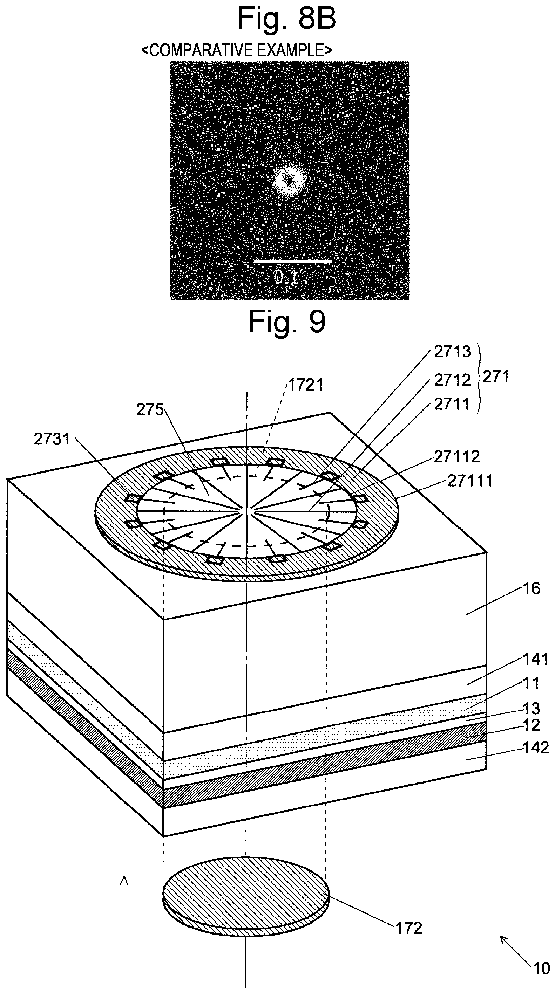

Next, the photonic density distribution in the active layer and the photonic density distribution in the cross section of the emitted laser beam were obtained by calculation on the assumption of the electric current density distribution corresponding to each of the case where the thickness of the sub-region 1712 is 10 µm in the first embodiment and the case of the comparative example. The photonic density distribution in the active layer is illustrated in Fig. 7A for the first embodiment and in Fig. 7B for the comparative example. The photonic density distribution in the cross section of the laser beam is illustrated in Fig. 8A for the first embodiment and in Fig. 8B for the comparative example. In both the active layer and the cross section of the laser beam, the difference between the photonic density around the center and the photonic density near the end is smaller in the first embodiment than in the comparative example, and a photonic density distribution close to being uniform is obtained.

### (2) Second Embodiment

### (2-1) Configuration of two-dimensional photonic crystal laser of second embodiment

Fig. 9 illustrates a configuration of a two-dimensional photonic crystal laser 20 of the second embodiment. The two-dimensional photonic crystal laser 20 of the second embodiment has the same configuration as the two-dimensional photonic crystal laser 10 of the first embodiment except that the configurations of the first electrode 271 and the opening 275 are different from the configurations of the first electrode 171 and the opening 175 in the first embodiment. Therefore, components other than the first electrode 271 and the opening 275 are denoted by the same reference numerals as those in the first embodiment, and description of them is omitted. Hereinafter, the configurations of the first electrode 271 and the opening 275 will be described.

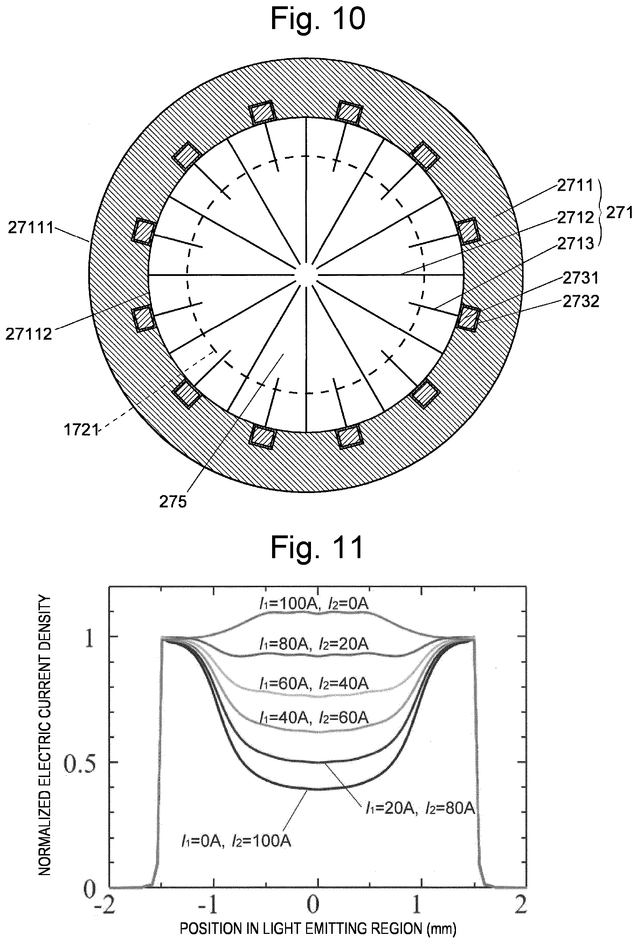

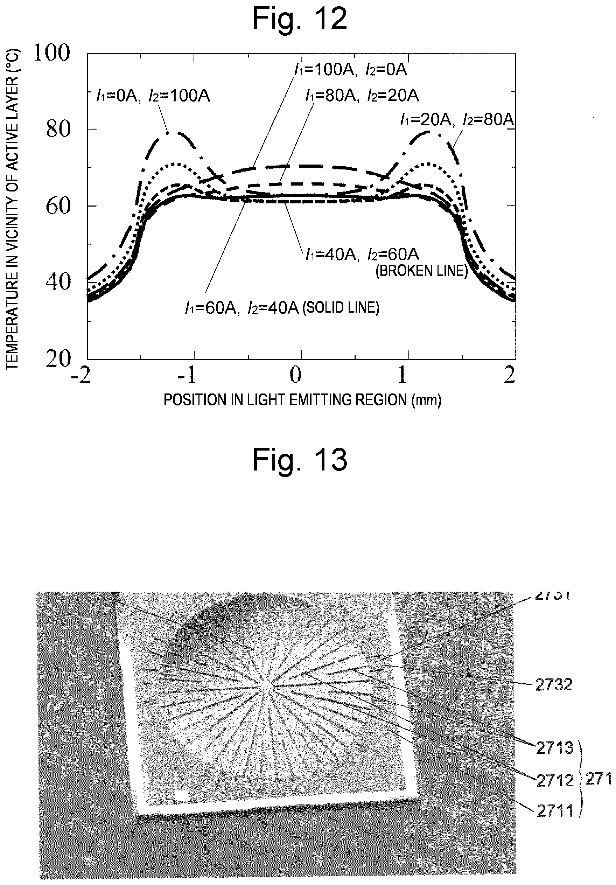

The first electrode 271 has a shape in which a main region 2711, first sub-region 2712, and a second sub-region 2713 are combined as illustrated in Fig. 10. The main region 2711 has a planar shape obtained by hollowing out the inside of a first circle (an outer edge 27111 of the first electrode 271) with a second circle 27112 having a smaller diameter than the outer edge 27111 and having the same center as the outer edge 27111. The first sub-region 2712 has a line shape extending from periphery of the second circle 27112 into the second circle 27112. The 12 first sub-regions 2712 are provided at 30° intervals so as to extend radially from the center of the second circle 27112, but are not formed within a predetermined distance from the center. In the example illustrated in Fig. 10, all the first sub-regions 2712 have the same length, but a plurality of the first sub-regions 2712 having different lengths may be used as illustrated in Fig. 13 to be described later. The main region 2711 and the first sub-region 2712 are physically integrated.

The second sub-region 2713 is disposed within the second circle 27112 and is made of a conductor of a line shape physically separated from the main region 2711 and the first sub-region 2712. The 12 second sub-regions 2713 are provided at 30° intervals so as to extend radially from the center of the second circle 27112 at positions shifted by 15° from the first sub-region 2712. The second sub-region 2713 is shorter in length than the first sub-region 2712 and is disposed at a position closer to the circumference portion of the second circle 27112. In the present embodiment, a part of each of the first sub-region 2712 and the second sub-region 2713 is located in the projection (and the second projection) 1721 onto the first electrode 271 of the second electrode 172, but one of the first sub-region 2712 and the second sub-region 2713 may be disposed outside the projection 1721. In addition, in the present embodiment, all the second sub-regions 2713 have the same length, but a plurality of the second sub-regions having different lengths may be used. The length of the second sub-region 2713 may be the same as that of the first sub-region 2712 or may be longer than that of the first sub-region 2712.

Each of the plurality of conductors of the second sub-regions 2713 is electrically connected to the plurality of electrode pads 2731 embedded in the main region 2711 on a one-to-one basis. Each of the electrode pads 2731 and the main region 2711 are separated by a groove (air) 2732. Some (two or more) or all of the plurality of second sub-regions 2713 may be electrically connected to each other. Instead of the groove (air) 2732, an insulating material made of an insulator or a material made of a semiconductor having higher electric resistance than the conductor may be used.

In the second embodiment, a portion of the second circle 27112 excluding the first sub-region 2712 and the second sub-region 2713 is the opening 275.

### (2-2) Operation of two-dimensional photonic crystal laser of second embodiment

Next, an operation of the two-dimensional photonic crystal laser 20 of the second embodiment will be described. A predetermined voltage (referred to as "first voltage") is applied between the main region 2711 and the first sub-region 2712 of the first electrode 271, and the second electrode 172, and a predetermined voltage (referred to as "second voltage") is also applied between the second sub-region 2713 of the first electrode 271 and the second electrode 172. Consequently, a first electric current I₁ flows between the main region 2711 and the first sub-region 2712, and the second electrode 172, and a second electric current I₂ flows between the second sub-region 2713 and the second electrode 172. Note that the first voltage and the second voltage can have different values (may have the same value). In addition, it is possible to apply only one of the first voltage and the second voltage.

Since the first sub-region 2712 of the first electrode 271 extends into the projection 1721 of the circumscribed circle of the second electrode (or of the second electrode itself), the electric current density formed around the center of the active layer 11 by the first electric current I₁ may be larger than that in the case where there is no first sub-region 2712, and furthermore, the electric current density may be higher around the center of the active layer 11 than in the periphery. On the other hand, since the second sub-region 2713 is disposed only up to a position closer to the outside than the first sub-region 2712 is, the second electric current I₂ has a greater tendency to form an electric current density distribution having a smaller electric current density around the center than the periphery than the first electric current I₁ does. Therefore, in a case where the electric current density distribution in which the electric current density is higher around the center of the active layer 11 than in the periphery is formed by the first electric current I₁, the ratio of the electric current density distribution formed by the second electric current I₂ is increased by adjusting the values of the first voltage and the second voltage, so that the electric current density distribution in which the first electric current I₁ and the second electric current I₂ are combined can be adjusted so as to be closer to a uniform electric current density distribution.

Alternatively, when a non-uniform temperature distribution occurs during use of the two-dimensional photonic crystal laser 20, the electric current density distribution may be adjusted so as to make the temperature distribution closer to a uniform temperature distribution by adjusting the values of the first voltage and the second voltage.

In addition, due to a manufacturing error when the two-dimensional photonic crystal layer 12 is manufactured, a difference may occur in an interval (lattice point interval) at which the modified refractive index regions 122 are disposed and a size of the modified refractive index region 122 for each position. Alternatively, a non-uniform temperature distribution may occur during use of the two-dimensional photonic crystal laser 20. In these cases, a difference (frequency distribution) occurs for each position in a resonance frequency (resonance wavelength) of light at each position in the two-dimensional photonic crystal layer 12, whereby some positions do not contribute to laser oscillation or multimode oscillation occurs, so that the shape of the laser beam may be disturbed. In such a case, by adjusting the electric current density distribution by changing the voltage applied from each of the plurality of electrode pads 2731, the influence of the frequency distribution in the two-dimensional photonic crystal layer 12 can be reduced, and the shape of the laser beam can be improved.

By adjusting the electric current density distribution in the active layer 11 in this manner, the distribution of the light emission intensity in the active layer 11 can also be made close to being uniform. Furthermore, also in the cross section of the laser beam generated by amplifying the light generated in the active layer 11 in the two-dimensional photonic crystal layer 12, the intensity distribution of the light becomes close to being uniform.

In Fig. 11, a result obtained by calculating an electric current density in the active layer 11 for the two-dimensional photonic crystal laser 20 of the second embodiment is indicated in a graph. Here, the calculation was performed for six cases where the ratio of the first electric current I₁ to the second electric current I₂ is different in a case where the first electric current I₁ and the second electric current I₂ are caused to flow 100 A in total. As a result, when the first electric current I₁ was 80 A and the second electric current I₂ was 20 A, the electric current density in the entire light emitting region became closest to being uniform.

Fig. 12 indicates a result obtained by calculating the temperature distribution in the vicinity of the active layer 11 for six cases in which the ratio of the first electric current I₁ and the second electric current I₂ is different as in Fig. 11 in a case where the two-dimensional photonic crystal laser 20 of the second embodiment is continuously operated. As a result, when the first electric current I₁ was 60 A and the second electric current I₂ was 40 A (data indicated in Fig. 12 by solid lines), the temperature distribution became closest to being uniform.

When a non-uniform temperature distribution is generated in the light emitting region, a refractive index distribution is generated in the two-dimensional photonic crystal layer 12, and the oscillation mode may become unstable. On the other hand, by adjusting the ratio of the first electric current I₁ and the second electric current I₂ at the time of continuous operation as described above, the temperature distribution is made close to being uniform, so that stable laser oscillation can be obtained.

Next, a result obtained by manufacturing the two-dimensional photonic crystal laser of the second embodiment and measuring the light emission intensity in the active layer 11 will be described. Fig. 13 illustrates an appearance of a manufactured two-dimensional photonic crystal laser. In this two-dimensional photonic crystal laser, twenty first sub-regions (sub-regions not physically separated from the main region 2711) 2712 are provided at 18° intervals. Among them, ten first sub-regions 2712 provided at 36° intervals extend to positions close to the center of the second circle 27112 than the other ten first sub-regions 2712 do. Twenty second sub-regions (sub-regions physically separated from the main region 2711) 2713 are provided at 18° intervals. Each of the second sub-regions 2713 is disposed between two first sub-regions 2712 adjacent to each other such that a distance from both the first sub-regions 2712 is equal.

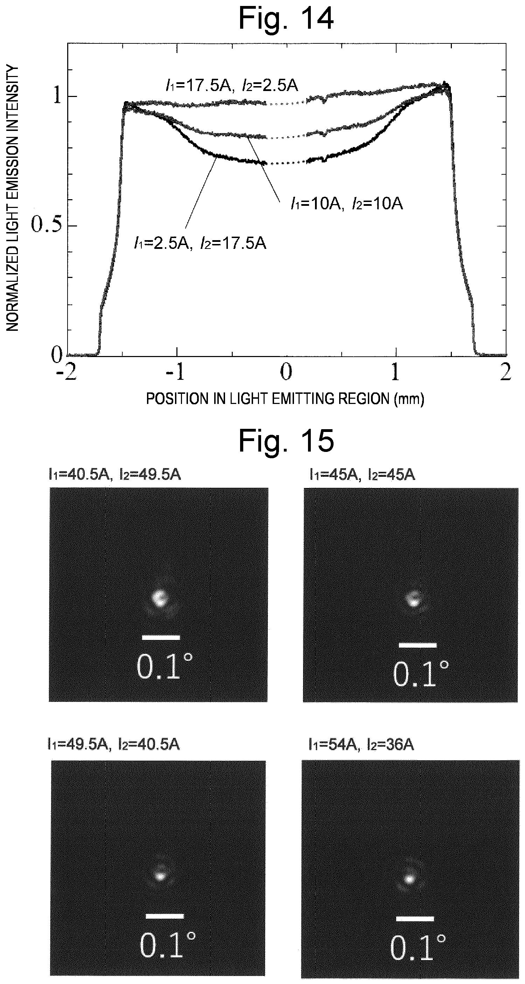

Fig. 14 indicates a measurement result of the light emission intensity in the active layer 11 of the manufactured two-dimensional photonic crystal laser. The measurement was performed for three cases where the first electric current I₁ and the second electric current I₂ are caused to flow 20 A in total and the ratio of the first electric current I₁ to the second electric current I₂ is different. As a result, when the first electric current I₁ was 17.5 A and the second electric current I₂ was 2.5 A, the electric current density in the entire light emitting region became closest to being uniform, and a substantially flat electric current density distribution was obtained over the entire light emitting region.

Fig. 15 illustrates a cross-sectional shape of a laser beam emitted from the manufactured two-dimensional photonic crystal laser 20. Here, experiments were performed for four cases where the first electric current I₁ and the second electric current I₂ are caused to flow 90 A in total and the ratio of the first electric current I₁ to the second electric current I₂ is different. From the four photographs indicated in Fig. 15, it can be seen that the cross-sectional shape of the beam changes when the ratio of the first electric current I₁ and the second electric current I₂ is changed. For example, when the first electric current I₁ is 40.5 A and the second electric current I₂ is 49.5 A as illustrated in the upper left of the drawing, a laser beam having a donut shape in which the vicinity of the center is darker than the periphery, and having a slightly expanded cross-sectional shape is emitted. From this state, when the first electric current I₁ is increased and the second electric current I₂ is decreased, the cross-sectional shape changes to a monomodal shape in which the vicinity of the center is brighter than the periphery, and the spread of the cross section decreases.

Next, an example will be described in which the electric current density distribution is adjusted in a case where the resonance frequency distribution of light is generated in the two-dimensional photonic crystal layer 12 due to a manufacturing error such as the lattice point interval and the size of the modified refractive index region 122 in the two-dimensional photonic crystal layer 12. Fig. 16A illustrates an example of such a frequency distribution. In the drawing, an electric current is supplied into a circular region (electric current supply region) in the active layer 11, and an electric current density distribution in a longitudinal cross section passing through the center of the electric current supply region is illustrated. A broken line in the drawing indicates a frequency distribution generated when the same voltage is applied from (the same potential is applied to) each of the plurality of electrode pads 2731 (the electric current density distribution is not adjusted), and this broken line indicates a tendency that the frequency decreases from one end to the other end (from a minus side to a plus side in terms of a numerical value of a position illustrated in the drawing) of the electric current supply region in the longitudinal cross section.

Therefore, the voltage applied from each of the electrode pads 2731 was adjusted such that the electric current density on the other end side was smaller than that in the case where the electric current density distribution was not adjusted, and difference in electric current density from the electric current density in the above case was larger from the one end toward the other end (Fig. 16B). As a result, as indicated by a solid line in Fig. 16A, the frequency distribution was closer to being uniform than when the electric current density distribution was not adjusted.

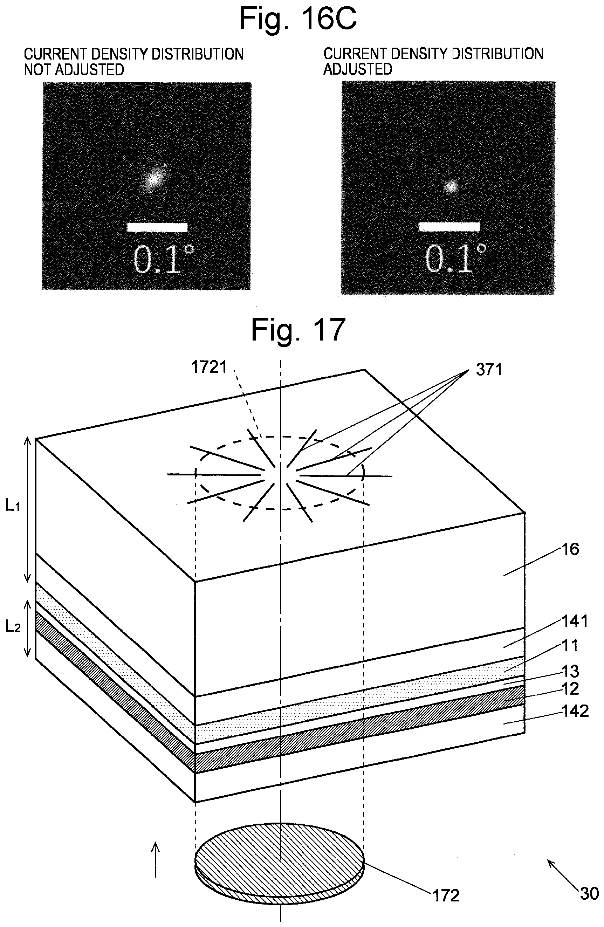

As illustrated in Fig. 16C, the cross-sectional shape of the laser beam in these two cases was a shape closer to a circle corresponding to the shape of the electric current supply region in the case where the electric current density distribution was not adjusted.

### (3) Third Embodiment

Fig. 17 illustrates a configuration of a two-dimensional photonic crystal laser 30 of the third embodiment. The two-dimensional photonic crystal laser 30 of the third embodiment has the same configuration as the two-dimensional photonic crystal laser 10 of the first embodiment except that the configuration of the first electrode 371 is different from the configurations of the first electrode 171 in the first embodiment. Therefore, components other than the first electrode 371 are denoted by the same reference numerals as those in the first embodiment, and description of them is omitted. Hereinafter, the configuration of the first electrode 371 will be described.

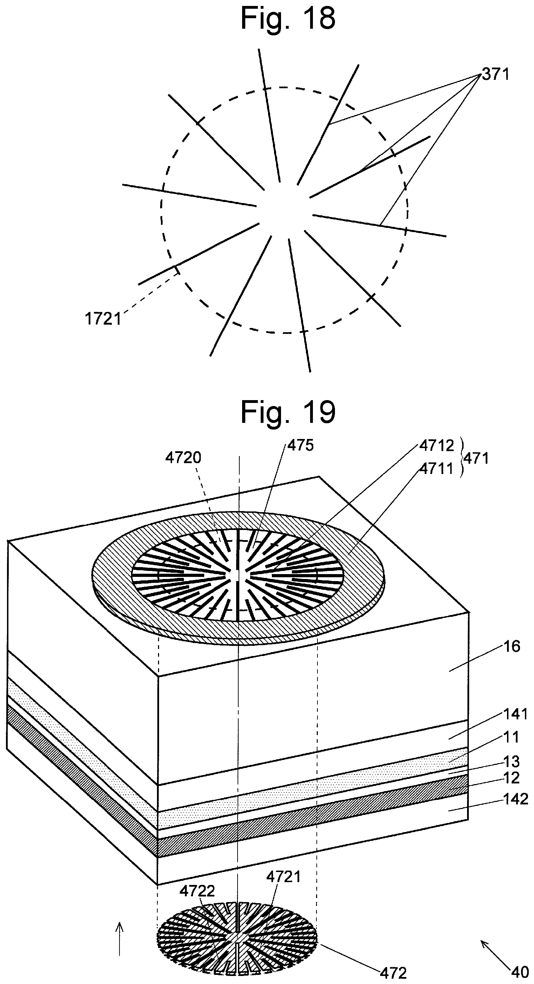

As illustrated in Fig. 18, the first electrode 371 is formed by radially disposing a plurality of conductor materials of a line shape. A part of each of the conductor materials of the first electrode 371, specifically, a part of the inner side of each of the conductor materials disposed radially is disposed within the projection 1721 of the second electrode 172 onto the first electrode 371. The first electrode 371 is not provided with those corresponding to the main region, the sub-region, and the opening in the first and the second embodiments.

A distance L₁ between the first electrode 371 and the surface of the active layer 11 on the first electrode 371 side is set to be longer than a distance L₂ between the second electrode 171 and the surface of the active layer 11 on the second electrode 172 side. In other words, the first electrode 371 is disposed at a position farther from the active layer 11 than the second electrode 172 is.

An operation of the two-dimensional photonic crystal laser 30 of the third embodiment will be described. By applying a predetermined voltage between the first electrode 371 and the second electrode 172, an electric current flows between both electrodes. Here, since the first electrode 371 is disposed at a position farther from the active layer 11 than the second electrode 172 is, in the active layer 11, a region having a shape close to the shape of the second electrode 172 is the electric current supply region and the light emitting region. In the present embodiment, since a part of the conductor material of the first electrode 371 is disposed within the projection 1721 of the second electrode 172 onto the first electrode 371, the electric current density around the center of the electric current supply region of the active layer 11 can be increased. As a result, it is possible to suppress a decrease in the light emission intensity around the center of the light emitting region, and it is possible to suppress a decrease in the intensity of light i around the center even in the cross section of the laser beam obtained by being amplified by the two-dimensional photonic crystal layer 12.

### (4) Fourth Embodiment

Fig. 19 illustrates a configuration of a two-dimensional photonic crystal laser 40 of the fourth embodiment. The two-dimensional photonic crystal laser 40 of the fourth embodiment has the same configuration as the two-dimensional photonic crystal laser 10 of the first embodiment except that the configurations of the first electrode 471 and the second electrode 472 are different from the configuration of the first electrode 171 in the first embodiment. Therefore, components other than the first electrode 471 and the second electrode 472 are denoted by the same reference numerals as those in the first embodiment, and description of them is omitted. In the first electrode 471, the main region 4711 has the same configuration as the main region 1711 of the first embodiment, and the sub-region 4712 of a line shape, except for the length and the width, similarly to the sub-region 1712 of the first embodiment, extends from the main region 4711 to the inside of the projection (second projection) 4720 of the circumscribed circle of the second electrode 472. Note that the first electrode 171 of the first embodiment may be used as it is for the two-dimensional photonic crystal laser 40 of the fourth embodiment. Hereinafter, the configuration of the second electrode 472 will be described.

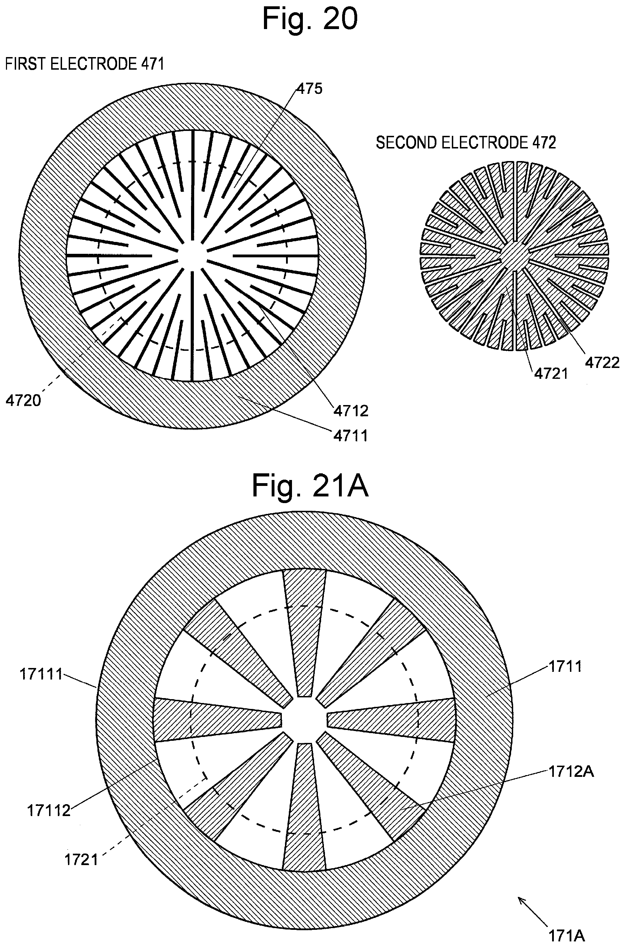

Fig. 20 illustrates configurations of the first electrode 471 and the second electrode 472 in plan views. The second electrode 472 has a non-conductive portion 4722 formed by cutting off a part of a conductor of a plate shape, and a conductive portion 4721 other than the non-conductive portion 4722. The non-conductive portion 4722 is provided in a region corresponding to the third projection, the third projection being is a projection of a portion, out of the first electrode 471, protruding into the second projection 4720, that is, a projection of a portion inside the second projection 4720, out of the sub-region 4712, onto the second electrode 472. Note that the non-conductive portion 4722 may be formed by forming a film of an insulator material at a portion corresponding to the non-conductive portion 4722 out of the conductor of a plate shape instead of cutting off a part of the conductor.

The laser beam amplified and emitted by the two-dimensional photonic crystal layer 12 passes through the opening 475 of the first electrode 471, and is also blocked in the sub-region 4712. Therefore, in the present embodiment, the region corresponding to the third projection in the second electrode 472 is set as the non-conductive portion 4722, so that the electric current supplied to the portion corresponding to the projection of the sub-region 4712 out of the active layer 11 and the two-dimensional photonic crystal layer 12 is suppressed, and thus the light emission in the portion is suppressed. Consequently, it is possible to suppress, out of the laser beams, a laser beam generated by the light emission in the portion from being blocked by the sub-region 4712 and being wasted, and to increase the light emission efficiency.

Note that, in the fourth embodiment, the entire non-conductive portion 4722 has the same shape, size, and position as those of the entire third projection, but if the non-conductive portion 4722 is formed at least in a part of the third projection, there is an effect that the light emission efficiency can be increased. In the fourth embodiment, the first electrode 471 in which the main region 4711 and the sub-region 4712 of a line shape are combined is used. However, even in a case where a first electrode having such a shape that an opening at which the second projection is located and at least a part of the periphery of the opening protrude into the second projection is used instead, if at least a part of the projection of the protruding portion onto the second electrode is a non-conductive portion, the same effect as that of the fourth embodiment is exerted.

### (5) Modifications

The present invention is not limited to the above embodiments, and various modifications are possible.

For example, in the first and the second embodiments, the plurality of sub-regions 1712, the plurality of first sub-region 2712, and the plurality of second sub-region 2713 are correspondingly provided in the first electrode 171 at equal intervals (at intervals of 9° in Fig. 3 and at intervals of 36° in Fig. 10), but they may be provided at unequal intervals. In addition, a plurality of sub-regions having different widths, thicknesses, and materials may be used. Furthermore, although the plurality of sub-regions are provided in the first electrodes 171 and 271 in the first and the second embodiments, only one sub-region may be provided. Similarly, the conductor material in the first electrode 371 in the third embodiment and the first electrode 471 in the fourth embodiment may be disposed at unequal intervals or only one may be provided.

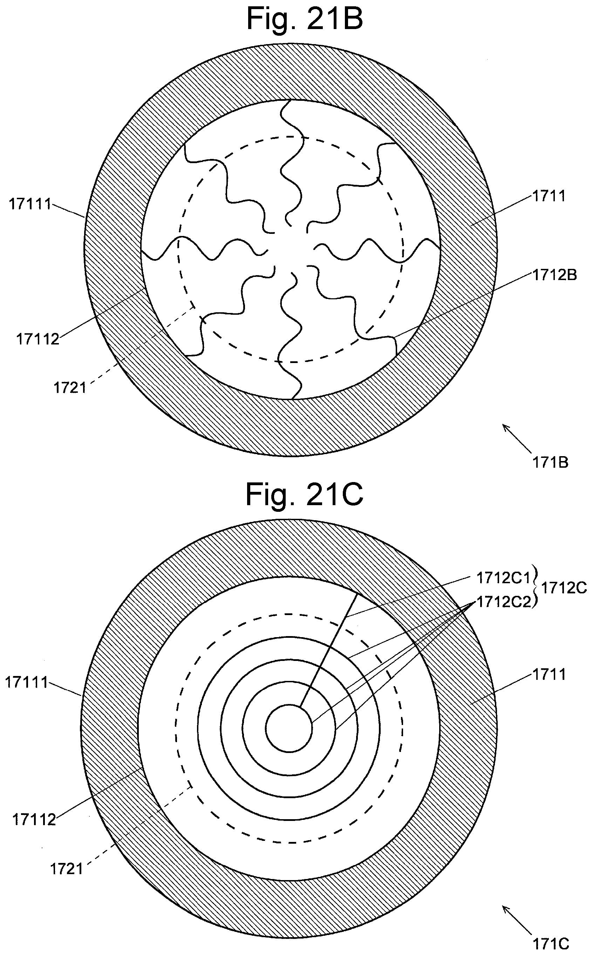

In addition, in the above embodiments, the sub-region 1712, the first sub-region 2712, the second sub-region 2713, and the sub-region 4712 each having a line shape are used, but sub-regions having other shapes may be used. For example, as illustrated in Fig. 21A, the first electrode 171A including the sub-regions 1712A having a band shape in which the width varies depending on the position may be used, and as illustrated in Fig. 21B, the first electrode 171B including the sub-regions 1712B having a curved shape may be used. Alternatively, sub-regions having different thicknesses and materials depending on positions may be used. Furthermore, sub-regions having various shapes such as a polygon such as a triangle, a part of a polygon, a circle, an ellipse, or a part of these can be used.

Alternatively, as illustrated in Fig. 21C, a first electrode 171C may be used which includes a sub-region 1712 C obtained by combining one first sub-region 1712C1 protruding from the periphery of the second circle 17112C of the main region 1711C into the second circle 17112C and a plurality of second sub-regions 1712C2 of an annular shape connected to the first sub-region 1712C and disposed concentrically. In this case, the number of the first sub-regions 1712C1 may be plural, and the number of the second sub-regions 1712C2 may be only one. In addition, the second sub-region 1712C2 is not limited to an annular shape, and a rectangular frame shape or the like may be used.

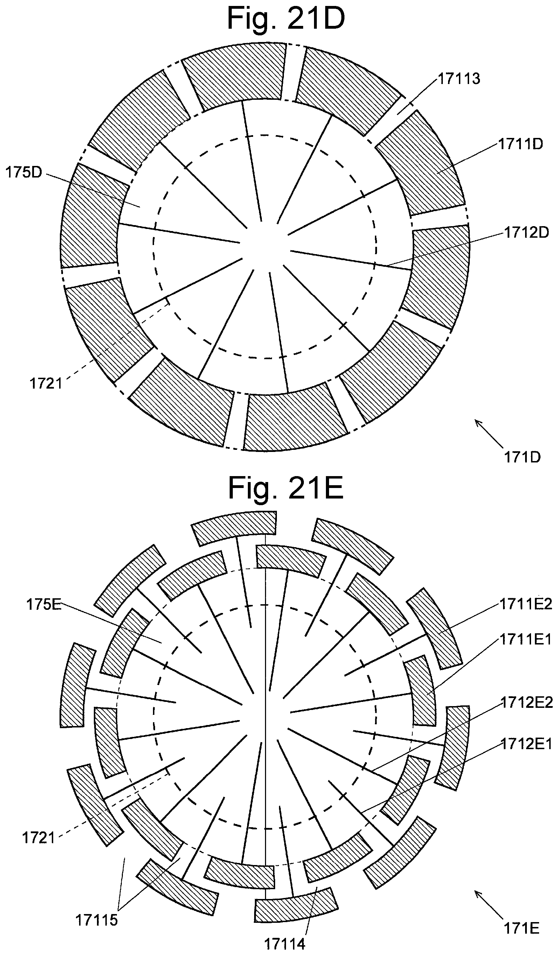

In addition, as illustrated in Fig. 21D, a first electrode 171D in which a main region 1711D is divided into a plurality of electrodes may be used. In the example of Fig. 21D, the first electrode is divided into a plurality of pieces by making cuts 17113 extending in a radial direction at equal intervals in the main region 1711 of the first electrode 171 of the first embodiment. Note that the cuts 17113 may be formed at unequal intervals. Out of the inside of the region of a donut shape formed by the main region 1711D and the cuts 17113, a portion excluding the sub-region 1721 corresponds to the opening (window) 175D.

Alternatively, as illustrated in Fig. 21E, the main region 1711 of the first electrode 171 of the first embodiment may be divided into two in the radial direction by making a cut 17114 in the circumferential direction, and the first electrode 171E divided into a plurality of pieces by making cuts 17115 extending in the radial direction in each of the two electrodes at equal intervals in the circumferential direction may be used. Note that the cuts 17115 may be formed at unequal intervals in any one or both of the two electrodes. The first electrode 171E has an inner main region 1711E1 divided into a plurality of electrodes and disposed inside in the radial direction, and an outer main region 1711E2 divided into a plurality of electrodes and disposed outside in the radial direction with respect to the inner main region 1711E1. A first sub-region 1711E1 is provided from each of the plurality of divided inner main regions 1712E1 toward the center of the circle (but not reaching the center), and a second sub-region 1711E2 is provided from each of the plurality of divided outer main regions 1712E2 toward the center of the circle (but not reaching the center). The second sub-region 1712E2 passes through the cut 17115 provided in the inner main region 1711E1, and the tip of the second sub-region 1712E2 extends into the projection 1721 of the circumscribed circle of the second electrode 172. Out of a region inside the inner main region 1711E1, a portion of the region where the first sub-region 1712E1 and the second sub-region 1712E2 are not provided corresponds to the opening (window) 175E.

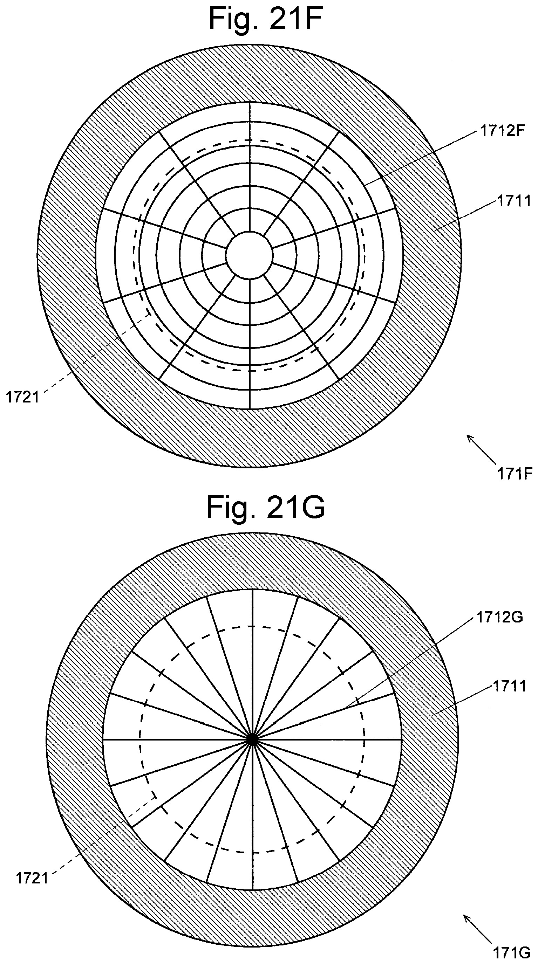

Besides, the first electrode 171F (Fig. 21F) in which the sub-regions 1712F are formed in a spider web shape, the first electrode 171G (Fig. 21G) in which the sub-regions 1712G extend radially from the center of a circle as a starting point, or the like may be used.

In the second embodiment, the first sub-regions 2712 and the second sub-regions 2713 are alternately provided, but a plurality of the first sub-regions 2712 or a plurality of the second sub-regions 2713 may be continuously provided. In addition, the second embodiment has a configuration in which the first sub-region 2712 is not physically separated from the main region 2711, but the first sub-region 2712 may also be physically separated from the main region 2711 similarly to the second sub-region 2713, and the voltage application control may be performed on the main region 2711, the first sub-region 2712, and the second sub-region 2713 independently from each other. Furthermore, the first electrode may be divided into four or more electrodes, and the voltage application control may be performed on the electrodes independently from each other. For example, the plurality of second sub-regions 2713 in the second embodiment can be regarded as independent divided electrodes, and the voltage application control can be performed on the main region 2711 and the first sub-region 2712, and the plurality of second sub-regions 2713 therefor independently from each other.

In a part of the first embodiment, the insulating film 1718 is provided between the conductor material of the first electrode 171 and the substrate 16 in the region outside the projection 1721 of the second electrode 172, but such an insulating film may be used in other embodiments and modifications. When an insulating film is provided in a portion of the opening (window), a material transparent to the laser beam is used as an insulator material which is a material of the insulating film.

Similarly, the second electrode 172 may be formed by forming the insulating film 1728 on a portion, out of the lower surface of the second cladding layer 142, where the second electrode 172 is not provided and then forming a film of the conductor material on the entire lower surface of the second cladding layer 142 and the entire lower surface of the insulating film 1728 (see Fig. 5). The conductor material formed as a film can function as a reflector 1727 configured to reflect the laser beam. As the insulator material which is the material of the insulating film 1728, either a transparent material or an opaque material for the laser beam may be used.

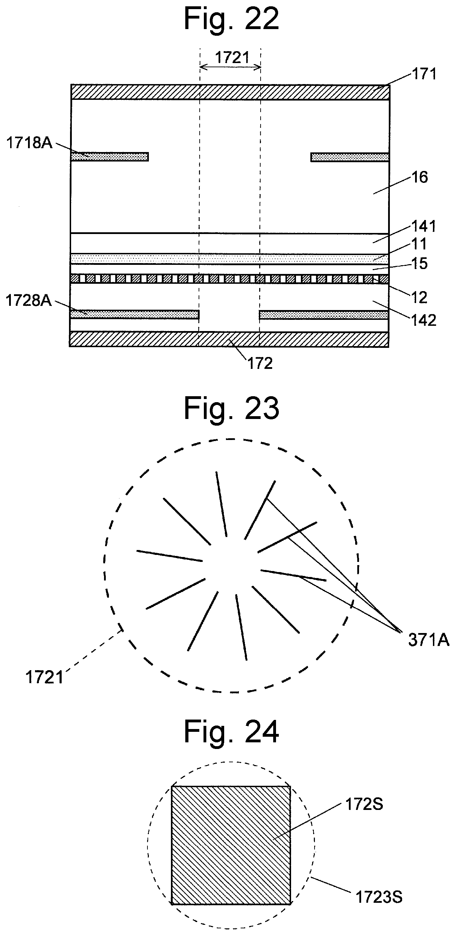

Instead of the insulating film 1718 on the first electrode 171 side and/or the insulating film 1728 on the second electrode 172 side, the following configuration may be used. For example, a member that does not form an ohmic contact with the first electrode 171 and/or the second electrode 172 or has high contact resistance with these electrodes can be provided at a position where the insulating film 1718 and/or the insulating film 1728 is provided in the above example. Alternatively, instead of the insulating film 1718, an opposite polarity region 1718A made of a p-type semiconductor having an opposite polarity to the n-type semiconductor constituting the substrate 16 or the first cladding layer 141 may be provided in a part in the thickness direction in the substrate 16 or the first cladding layer 141 and outside the projection 1721 (see Fig. 22). Similarly, instead of the insulating film 1728, an opposite polarity region 1728A made of a n-type semiconductor having an opposite polarity to the p-type semiconductor constituting the second cladding layer 142 may be provided in a part in the thickness direction in the second cladding layer 142 and outside the projection 1721 (see Fig. 22). The opposite polarity region 1718A and the opposite polarity region 1728A prevent conduction of electrons conducting in the substrate 16 or the first cladding layer 141 and conduction of positive hole holes conducting in the second cladding layer 142, thereby acting in a manner similar to an insulating film. Alternatively, instead of forming the opposite polarity region 1718A and/or 1728A, insulation may be performed by supplying ions (for example, hydrogen ions) at the same position as the opposite polarity region. Note that the various methods described in this paragraph may be used when the non-conductive portion is formed on the second electrode in the fourth embodiment.

The shape of the opening of the main region of the first electrode is circular in the above embodiments, but is not limited to this. For example, the main region may have a square or a regular hexagonal shape, or an amorphous shape.

In the third embodiment, the first electrode 371 is formed such that a part of the first electrode 371 is disposed in the projection 1721 of the second electrode 172 onto the first electrode 371. However, for example, as illustrated in Fig. 23, the entire first electrode 371A may be disposed in the projection 1721.

The shape of the outer edge of each of the first electrode and the second electrode is not limited to the circular shape in the above embodiments, and may be a square shape, a regular hexagonal shape, or an irregular shape. When the second electrode has a shape other than a circular shape, the shape of the circumscribed circle of the second electrode does not match the shape of the second electrode itself (see, for example, a square second electrode 172S and its circumscribed circle 1723S illustrated in Fig. 24), but at least the projection of the circumscribed circle onto the first electrode is located in the opening of the first electrode, and at least a part of the periphery of the opening protrudes into the projection. In addition, in this case, the second projection which is the projection of the second electrode itself onto the first electrode is located in the opening of the first electrode, and at least a part of the periphery of the opening protrudes into the second projection.

The shape and the size of the light emitting region in the active layer depend on the shape and the size of the outer edges of the first electrode and the second electrode, but it is preferable to set the shape and the size of the outer edges of the first electrode and the second electrode such that the diameter of an inscribed circle of the light emitting region is 1 mm or more. According to the present invention, the electric current density distribution can be made close to being uniform over a wide light emitting region where the diameter of the inscribed circle is 1 mm or more.

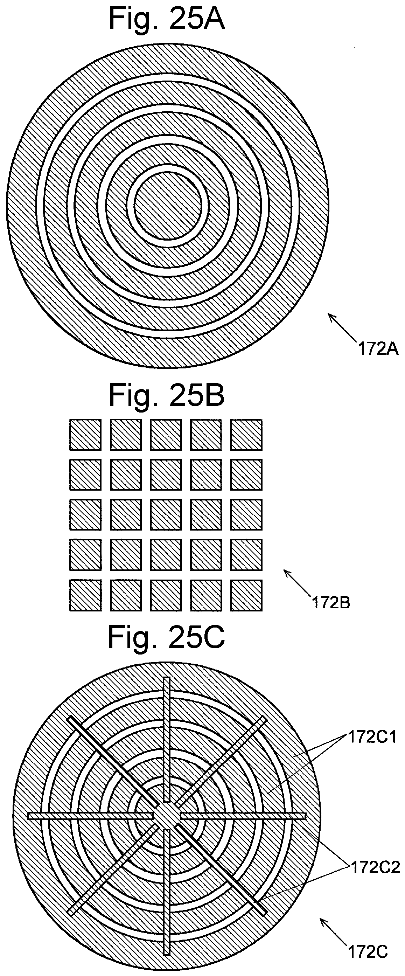

In the above embodiments, the second electrode 172 including one conductor is used, but a second electrode divided into a plurality of conductors may be used. For example, as illustrated in Fig. 25A, the second electrode 172A in which the conductor is divided into a plurality of pieces concentrically may be used, or the second electrode 172B in which the divided conductors are disposed in a square lattice pattern (or another lattice pattern) may be used. In these examples, since the divided conductors are electrically independent from each other, the electric current density distribution in the active layer 11 can be controlled by controlling the electric current flowing from the individual conductors. On the other hand, in the second electrode 172C illustrated in Fig. 25C, the conductor 172C1 divided into the plurality of pieces concentrically and the conductors 172C2 extending radially are electrically connected. In this case, the electric current flowing from each conductor cannot be controlled, but the electric current density distribution in the active layer 11 can be adjusted depending on the difference in dispositions of the conductors 172C1 and 172C2.

In the above embodiment, the first electrode having a shape in which the main region and the sub-region are combined is used, but the first electrode is not limited to such a shape. For example, as illustrated in Fig. 26, a first electrode 171H may be used in which an inner edge 17112H of a conductor material 1711H of a donut shape is provided so as to be located inside the projection (or second projection) 1721 of the second electrode 172. In this case, a region inside the edge 17112H is an opening (window) 175H.

### [Modes]

A person skilled in the art can understand that the previously described illustrative embodiment is a specific example of the following modes of the present invention.

(Clause 1) A two-dimensional photonic crystal laser according to one mode of the present invention includes:
an active layer;
a two-dimensional photonic crystal layer provided on one face of the active layer, in which modified refractive index regions are periodically and two-dimensionally disposed in a base member of a plate shape, the modified refractive index regions having a refractive index different from the refractive index of the base member; and
a first electrode and a second electrode provided so as to sandwich the active layer and the two-dimensional photonic crystal layer in a stacking direction;
in which
the first electrode has an opening, and
a projection of a circumscribed circle of the second electrode onto the first electrode is located in the opening, and
at least a part of periphery of the opening of the first electrode protrudes into the projection.

(Clause 2) A two-dimensional photonic crystal laser according to Clause 2 is characterized in that, in the two-dimensional photonic crystal laser according to Clause 1, the first electrode includes a main region surrounding the projection, and a sub-region of a line shape extending from the main region into the projection.

(Clause 3) A two-dimensional photonic crystal laser according to Clause 3 is characterized in that, in the two-dimensional photonic crystal laser according to Clause 1, a second projection which is a projection of the second electrode onto the first electrode is located in the opening, and at least a part of the periphery of the opening protrudes into the second projection.

(Clause 4) A two-dimensional photonic crystal laser according to Clause 4 is characterized in that, in the two-dimensional photonic crystal laser according to Clause 3, a non-conductive portion is formed on the second electrode, where the non-conductive portion is at least a part of a third projection onto the second electrode of the part of the first electrode protruding into the second projection.

(Clause 5) A two-dimensional photonic crystal laser according to Clause 5 is characterized in that, in the two-dimensional photonic crystal laser according to Clause 3 or 4, the first electrode includes a main region surrounding the second projection, and a sub-region of a line shape extending from the main region into the second projection.

(Clause 6) A two-dimensional photonic crystal laser according to Clause 6 is characterized in that, in the two-dimensional photonic crystal laser according to Clause 2 or 5, a plurality of the sub-regions in which any one or two or more of a length, a width, a thickness, and a material are different.

(Clause 7) A two-dimensional photonic crystal laser according to Clause 7 is characterized in that, in the two-dimensional photonic crystal laser according to any one of Clauses 1 to 6, the first electrode is physically divided into a plurality of electrodes.

(Clause 8) A two-dimensional photonic crystal laser according to Clause 8 is characterized in that, in the two-dimensional photonic crystal laser according to any one of Clauses 1 to 7, an area of a part of the first electrode inside the projection is larger than an area outside the projection.

(Clause 9) A two-dimensional photonic crystal laser according to Clause 9 is characterized in that, in the two-dimensional photonic crystal laser according to any one of Clauses 1 to 8, the modified refractive index region is a combination of two holes or two members having a refractive index different from a refractive index of the base member.

(Clause 10) A two-dimensional photonic crystal laser according to Clause 10 includes:
an active layer;
a two-dimensional photonic crystal layer provided on one face of the active layer, in which modified refractive index regions are periodically and two-dimensionally disposed in a base member of a plate shape, the modified index regions having a refractive index different from the refractive index of the base member; and
a first electrode and a second electrode provided so as to sandwich the active layer and the two-dimensional photonic crystal layer in a stacking direction;
in which
the first electrode is disposed at a position farther from the active layer than the second electrode is, and
at least a part of the first electrode exists in the projection of the circumscribed circle of the second electrode onto the first electrode.

(Clause 11) A two-dimensional photonic crystal laser according to Clause 11 is characterized in that, in the two-dimensional photonic crystal laser according to any one of Clauses 1 to 10, a value obtained by dividing an electric current density at an outer edge of a light emitting region by an electric current density at a center of the light emitting region of the active layer when a voltage is applied between the first electrode and the second electrode is 0.2 or more and 1.2 or less.

(Clause 12) A two-dimensional photonic crystal laser according to Clause 12 is characterized in that, in the two-dimensional photonic crystal laser according to Clause 11, a diameter of an inscribed circle of the light emitting region is 1 mm or more.

### REFERENCE SIGNS LIST

10, 20, 30, 40, 90... Two-Dimensional Photonic Crystal Laser
11, 91... Active Layer
12, 92... Two-Dimensional Photonic Crystal Layer
121... Base Member
122... Modified Refractive Index Region
1221... First Modified Refractive Index Region
1222... Second Modified Refractive Index Region
13... Spacer Layer
141, 941... First Cladding Layer
142, 942... Second Cladding Layer
16, 96... Substrate
171, 171A, 171B, 171C, 171D, 171E, 171F, 171G, 171H, 271, 371, 371A, 471... First Electrode
1711, 1711C, 1711D, 2711, 4711... Main Region
1711H... Conductor Material of First Electrode
17111, 27111... First Circle (Outer Edge of First Electrode)
17112, 17112C, 27112... Second Circle
17112H... Inner Edge of Conductor Material
17113... Cut in Main Region
1712, 1712A, 1712B, 1712C, 1711D, 2712, 4712... Sub-region
1712C1... First Sub-region
1712C2... Second Sub-region
1718, 1728... Insulating Film
1718A, 1728A... Opposite Polarity Region
172, 172A, 172B, 172C, 172S, 472... Second Electrode
1721... Projection of Second Electrode onto First Electrode
1723S... Circumscribed Circle of Second Electrode
1727... Reflector
175, 175A, 175D, 175E, 175H, 275, 475, 975... Opening (Window)
18, 98... Electric Current
181, 981... Light Emitting Region
2731... Electrode Pad
2732... Groove (Air)
4720... Second Projection
4721... Conductive Portion of Second Electrode
4722... Non-conductive Portion of Second Electrode
9421... Surface of Second Cladding Layer
971... Window-shaped Electrode
972... Electrode
9721... Projection of Electrode 972

## Claims

1. A two-dimensional photonic crystal laser, comprising:
an active layer;
a two-dimensional photonic crystal layer provided on one face of the active layer, in which modified refractive index regions are periodically and two-dimensionally disposed in a base member of a plate shape, the modified refractive index regions having a refractive index different from the refractive index of the base member; and
a first electrode and a second electrode provided so as to sandwich the active layer and the two-dimensional photonic crystal layer in a stacking direction;
wherein
the first electrode has an opening, and
a projection of a circumscribed circle of the second electrode onto the first electrode is located in the opening, and
at least a part of periphery of the opening of the first electrode protrudes into the projection.

2. The two-dimensional photonic crystal laser according to claim 1, wherein the first electrode includes a main region surrounding the projection, and a sub-region of a line shape extending from the main region into the projection.

3. The two-dimensional photonic crystal laser according to claim 1, wherein a second projection which is a projection of the second electrode onto the first electrode is located in the opening, and at least a part of the periphery of the opening protrudes into the second projection.

4. The two-dimensional photonic crystal laser according to claim 3, wherein a non-conductive portion is formed on the second electrode, where the non-conductive portion is at least a part of a third projection onto the second electrode of the part of the first electrode protruding into the second projection.

5. The two-dimensional photonic crystal laser according to claim 3, wherein the first electrode includes a main region surrounding the second projection, and a sub-region of a line shape extending from the main region into the second projection.

6. The two-dimensional photonic crystal laser according to claim 2 or 5, comprising a plurality of the sub-regions in which any one or two or more of a length, a width, a thickness, and a material are different.

7. The two-dimensional photonic crystal laser according to any one of claims 1 to 5, wherein the first electrode is physically divided into a plurality of electrodes.

8. The two-dimensional photonic crystal laser according to any one of claims 1 to 5, wherein an area of a part of the first electrode inside the projection is larger than an area outside the projection.

9. The two-dimensional photonic crystal laser according to any one of claims 1 to 5, wherein the modified refractive index region is a combination of two holes or two members having a refractive index different from a refractive index of the base member.

10. A two-dimensional photonic crystal laser comprising:
an active layer;
a two-dimensional photonic crystal layer provided on one face of the active layer, in which modified refractive index regions are periodically and two-dimensionally disposed in a base member of a plate shape, the modified index regions having a refractive index different from the refractive index of the base member; and
a first electrode and a second electrode provided so as to sandwich the active layer and the two-dimensional photonic crystal layer in a stacking direction;
wherein
the first electrode is disposed at a position farther from the active layer than the second electrode is, and
at least a part of the first electrode exists in the projection of the circumscribed circle of the second electrode onto the first electrode.
